# EUROPEAN PATENT SPECIFICATION

(11) **EP 3 005 136 B1**
(45) Date of publication and mention of the grant of the patent: **14.09.2022**
(21) Application number: 14807224.2
(22) Date of filing: 28.04.2014
(51) Int. Cl.: G06F 30/13

(54) **SYSTEMS AND METHODS FOR FEEDBACK WHILE DESIGNING AN ARCHITECTURAL STRUCTURE**
SYSTEME UND VERFAHREN FÜR EIN FEEDBACK BEIM ENTWURF EINES ARCHITEKTONISCHEN BAUWERKS
SYSTÈMES ET PROCÉDÉS D'INFORMATIONS EN RETOUR LORS DE LA CONCEPTION D'UNE STRUCTURE ARCHITECTURALE

(30) Priority: 06.06.2013 US 201361832110 P; 20.08.2013 US 201313970745
(43) Date of publication of application: 13.04.2016
(73) Proprietor: Sefaira, Inc., New York, NY 10003 (US)
(72) Inventor: SWARTZ, David, Wightman, Brooklyn, NY 11238 (US); MARCEAU, Guillaume, Brooklyn, NY 11216 (US); RAJ, Ritwik, New York, NY 10028 (US); MILES, Jacob, Brooklyn, NY 11217 (US); STERNER, Carl, Styan, New York, NY 11225 (US); GAYED, Jeremy, Washington Township, NJ 07676 (US); CHEN, Xiaomin, Forest Hills, NY 11375 (US); APPLE, Jonathan, Taylor, New York, NY 10003 (US); CSICSEK, Jeffrey, Stephen, Brooklyn, NY 11211 (US); SINGH, Varun, New York, NY 10023 (US); JENSEN, Mads, Naestholt, London W1U 4BY (GB); MARSHALL, Alexander, Little Wymondley Hertfordshire SG4 7HY (GB)
(74) Representative: Dolleymores
(86) International application number: PCT/US2014/035710
(87) International publication number: WO 2014/197136

(56) References cited:
- US-A1- 2012 079 061
- US-A1- 2012 079 061
- US-B1- 8 285 521
- US-B2- 7 610 181
- US-B2- 8 204 619
- None

## Description

### Technical Field

The technology disclosed herein relates to analysis of architectural structures, such as buildings. In particular, some embodiments provide analysis of an architectural structure, possibly at or near real-time, as the architectural structure is being designed by modeling software, such as a computer-aided design (CAD) software tool.

### Description of Related Art

During the design phase of an architectural structure, architects consider and analyze, among other things, where and how energy, water, materials, and other resources associated with the architectural structure (e.g., building, bridges, etc.) are being consumed or utilized. Generally, architects attempt to optimize their design of architectural structure for optimal resource consumption (e.g., energy, water, materials, etc.), lower construction costs, lower operational costs, and lower maintenance costs. In addition to lowering overall costs and resource uses, an optimized design may also improve a structure's compliance with building standards, certifications and ratings. Standards, certifications and ratings include green building certification and rating systems, such as Leadership in Energy & Environmental Design (LEED^{®}) and Code for Sustainable Homes (CSH), and environmental impact rating systems, such as Building Research Establishment Environment Assessment Method (BREEAM).

Optimizing the design of an architectural structure can often involve adding, removing, or otherwise modifying structural features of the architectural structure, floors, walls, roofs, or a fenestration (e.g., window or doorway). For example, an architect may use architectural-structure modeling software (e.g., computer-aided design [CAD] software) to modify the geometry, position, or type of a structural feature represented in an architectural structure design. Such modifications can influence the resource consumption, construction cost, operation cost, or maintenance cost of the architectural structure that constructed from the design.

Unfortunately, architects seeking to achieve sustainable architectural designs are finding themselves expending more and more time optimizing the design to achieve their particular sustainability goals. The expended time not only influences the development schedule for an architectural structure, but also proves to be disadvantageous when design documents need to be submitted in a timely fashion as proof of building standards compliance (e.g., green standards).

### Brief Summary of Embodiments

Various embodiments provide systems and methods enable a user to receive feedback regarding a computer-implemented design model, representing an architectural structure (e.g., office buildings, bridges, parking structures, shopping centers, etc.), as the user is designing or otherwise modifying the computer-implemented design using a computer-aided design (CAD) software tool. The feedback (hereafter also referred to as "design feedback") may provide the user with useful analysis information regarding the architectural structure's predicted characteristics (e.g., operational performance, resource consumption, cost, etc.) based on the current state of the computer-implemented design. As the user performs one or more actions on the computer-implemented design model (e.g., through the CAD software tool), particularly with respect to the geometry or texture of the computer-implemented design model, systems and methods can provide the impact of those actions, possibly at or near the time the actions were executed (e.g., at or near real-time). Actions by the user may result in modification of one or more design model elements of the computer-implemented design model. By providing (and updating) design feedback in this manner, the user may actively and immediately be informed of the impact their design change has on one or more predicted characteristics of the architectural structure and proceed accordingly. The design feedback may be provided automatically, based on modifications to the computer-implemented design model, without need for user to explicitly requesting analysis between modifications.

According to various embodiments of the disclosed technology, systems and methods can receiving, at a first computer system (e.g., server), design model delta data that describes a design difference between a first computer-implemented design model, representing an architectural structure in a first configuration, and a second computer-implemented design model representing, the architectural structure in a second configuration, wherein the second computer-implemented design model results from a modification performed on the first computer-implemented design model at a second computer system (e.g., client). In some embodiment, a computer-implemented design model may comprise one or more design model elements, such as lines, color, surface texture, faces and planes in a three-dimensional space, intended to represent features of the architectural structure, such as walls, floors, windows, roofs, and fenestrations. In some embodiments, the first and second computer-implemented design models may be computer-aided designs produced using a CAD software tool, such as Google^{®} Sketch-up or Autodesk^{®} AutoCAD^{®}.

The modification may be with respect to a design model element present in the first computer-implemented design model (e.g., a plane representing a window of the architectural structure), whereby the modification changes the architectural structure represented by the design model elements of the first computer-implemented design model from a first configuration to the architectural structure represented by the design model elements of the second computer-implemented design model. Modification of a computer-implemented design model element can include, without limitation, a change in the geometry, position, orientation, surface texture, color, or some other property of the design model element. Modification of a design model can also include, without limitation, an addition, removal, or adjustment to a design model element of the computer-implemented design model. Other example modifications may include various visual or non-visual modification applied to a computer-implemented design model through a computer-aided design (CAD) design software tool.

The design model delta data may comprise one or more modifications to a design model element of the first computer-implemented design model, including a modification to a geometry, a surface texture, position, or other property of a design model element. The design model delta data may comprise design model information that describes less than the design model information provided by the first computer-implemented design model and by the second computer-implemented design model. For example, the design model delta data may comprise only the differences between the first computer-implemented design model and the second computer-implemented design model and, thus, may comprise less data than a computer file containing the first computer-implemented design model or the second computer-implemented design model.

Eventually, the systems and methods can produce building data, based on the design model delta data, wherein the building data represents the architectural structure in the second configuration. Producing building data may comprise: mapping the design model delta data to building delta data configured to modify first building data, representing the architectural structure in the first configuration, to second building data, representing the architectural structure in the second configuration; and producing the building data based on the building delta data and previous building data representing the architectural structure in the first configuration. In some embodiments, building data describes building-related features of the architectural structure, including such structural elements as walls, floors, roofs, ceilings, or fenestrations (e.g., windows, doorways, etc.) of the architectural structure, which may be represented by design model elements in a computer-implemented design model.

Subsequently, based on the building data, the systems and methods can analyze an impact of the modification on a predicted characteristic of the architectural structure, thereby producing impact analysis data. Analyzing the impact of the modification may further comprise: analyzing the predicted characteristic of the architectural structure in the first configuration based on the pervious building data, thereby producing first analysis data; analyzing the predicted characteristic of the architectural structure in the second configuration based on the building data, thereby producing second analysis data; and comparing the first analysis data to the second analysis data to determine the impact of the modification to the predicted characteristic of the architectural structure. In some embodiments, analyzing the impact of the modification may further comprise identifying the predicted characteristic impacted by the modification. In some embodiments, analyzing the impact of the modification may further comprise determining a value representing the impact on the predicted characteristic. The value may be a difference value (e.g., expressed as a percentage) between a previous value associated with the predicted characteristic of the architectural structure as represented by the first computer-implemented design model, and a new value associated with the predicted characteristic of the architectural structure as represented by the second computer-implemented design model. Alternatively, the value may be an updated value associated with the predicted characteristic of the architectural structure as represented by the second computer-implemented design model.

In some embodiments, the predicted characteristic of the architectural structure may comprise resource consumption by the architectural structure, such as energy, water, or fuel consumption. Other predicted characteristics can include, without limitation, a thermal characteristic of the architectural structure, compliance of the architectural structure with a construction standard, carbon footprint of the architectural structure, indoor environment quality of the architectural structure, equipment utilization by the architectural structure, a construction cost of the architectural structure, an operational cost of the architectural structure, or a maintenance cost of the architectural structure.

Thereafter, the systems and methods can provide the impact analysis data for presentation at the second computer system as design feedback. The design feedback may comprise graphical or text-based information, where graphical information may include a modification to the appearance of the second computer-implemented design model as visually rendered at the second computer system. For some embodiments, the design feedback can be presented through the CAD software tool being used (e.g., by an architect) to modify the first computer-implemented design model to be the second computer-implemented design model.

According to some embodiment, the systems and methods can monitor for user actions, at the second computer system (e.g., client), with respect to the first computer-implemented design model, and detect for a user action that results in a given modification of the first computer-implemented design model. The system and methods can generate design model delta data relating to the given modification, and provide the design model delta data for analysis to determine an impact of the modification on a predicted characteristic of the architectural structure. The system and methods can receive impact analysis data relating to the impact of the modification on the predicted characteristic of the architectural structure. Subsequently, the impact analysis data may be presented as design feedback, possibly in connection with the modification of the computer-implemented design model.

In certain embodiments, providing the design model delta data for analysis may comprise the second computer system (e.g., client) providing the design model delta data to the first computer system (e.g., server), and receiving the impact analysis data may comprise the second computer system receiving the impact analysis data from the first computer system. In particular embodiments, the first computer system is a server and the second computer system is a client. The first computer system may be a server implemented using one or more cloud-based resources.

According to some embodiments of the disclosed technology, a computer program product comprises code configured to cause a computer system to perform various operations described herein. Additionally, some embodiments may be implemented using a computer system as described herein.

Other features and aspects of the disclosed technology will become apparent from the following detailed description, taken in conjunction with the accompanying drawings, which illustrate, by way of example, the features in accordance with embodiments of the disclosed technology. The summary is not intended to limit the scope of any inventions described herein, which are defined solely by the claims attached hereto.

### Brief Description of the Drawings

The technology disclosed herein, in accordance with one or more various embodiments, is described in detail with reference to the following figures. The drawings are provided for purposes of illustration only and merely depict typical or example embodiments of the disclosed technology. These drawings are provided to facilitate the reader's understanding of the disclosed technology and shall not be considered limiting of the breadth, scope, or applicability thereof. It should be noted that for clarity and ease of illustration these drawings are not necessarily made to scale.
Figure 1 is a block diagram illustrating an example architectural structure analysis system in accordance with some embodiments of the technology described herein.
Figure 2 is a block diagram illustrating an example architectural structure analysis system in accordance with some embodiments of the technology described herein.
Figure 3 is a visual rendering of an example computer-implemented design model representing an example architectural structure in accordance with some embodiments of the technology disclosed herein.
Figure 4 a flowchart illustrating an example method for analyzing an architectural structure in accordance with some embodiments of the technology disclosed herein.
Figure 5 a flowchart illustrating an example method for analyzing an architectural structure in accordance with some embodiments of the technology disclosed herein.
Figures 6A and 6B provide screenshots illustrating design feedback during design a computer-implemented design model representing an example architectural structure in accordance with some embodiments of the technology disclosed herein.
Figure 7 provides a screenshot of an example graphical-user interface (GUI) panel for architectural structure analysis in accordance with some embodiments of the technology disclosed herein.
Figures 8A-8D provide screenshots illustrating design feedback during design of a computer-implemented design model representing an example architectural structure in accordance with some embodiments of the technology disclosed herein.
Figures 9A and 9B provide screenshots illustrating an example of modifying a computer-implemented design model representing an example architectural structure in accordance with some embodiments of the technology disclosed herein.
Figure 10 provides a screenshot of an example graphical-user interface (GUI) panel for modifying a computer-implemented design model representing an example architectural structure in accordance with some embodiments of the technology disclosed herein.
Figure 11 provides a screenshot illustrating an example of modifying a computer-implemented design model representing an example architectural structure in accordance with some embodiments of the technology disclosed herein.
Figures 12A-12D provide screenshots illustrating visual design feedback during design of a computer-implemented design model representing an example architectural structure in accordance with some embodiments of the technology disclosed herein.
Figures 13A and 13B provide screenshots illustrating visual design feedback during design of a computer-implemented design model representing an example architectural structure in accordance with some embodiments of the technology disclosed herein.
Figure 14 illustrates an example computing module that may be used in implementing various features of embodiments of the disclosed technology.

The figures are not intended to be exhaustive or to limit inventions described herein to the precise form disclosed. It should be understood that any invention described herein can be practiced with modification and alteration, and that the disclosed technology be limited only by the claims and the equivalents thereof.

### Description of Embodiments of the Technology

Various embodiments provide systems and methods provide a user with design feedback regarding a computer-implemented design model, representing an architectural structure (e.g., office buildings, bridges, parking structures, shopping centers, etc.), as the user is designing or otherwise modifying the computer-implemented design using a computer-aided design (CAD) software tool. The design feedback may be provided automatically, based on modifications to the computer-implemented design model, without need for user to explicitly requesting analysis between modifications.

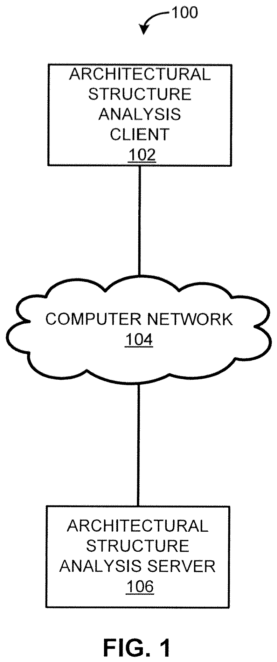

FIG. 1 is a block diagram illustrating an example architectural structure analysis system in accordance with some embodiments of the technology described herein. In particular, FIG. 1 illustrates an example environment 100 that includes an architectural structure analysis client 102, an architectural structure analysis server 106, and a computer network 104 configured to facilitate data communication between the architectural structure analysis client 102 and the architectural structure analysis server 106. The computer network 104 may comprise one or more network devices (e.g., switches, routers, and access points), networks (e.g., local-area networks [LANs], wide-area networks [WANs], and metropolitan-area networks [MANs]), and network links (e.g., wireless and wired links), which facilitate data communication between the architectural structure analysis client 102 and the architectural structure analysis server 106. For some embodiments, each of the architectural structure analysis client 102 and the architectural structure analysis server 106 can respectively be implemented using one or more separate computer systems. For example, while the architectural structure analysis client 102 may be implemented in a user-oriented computer system, such as a desktop computing device or a mobile computing device (e.g., smartphone, tablet, and laptop), the architectural structure analysis server 106 can be implemented on one or more server computing system, such as those generally used in providing cloud-based computing services. Those skilled in the art will appreciate that for some embodiments, the architectural structure analysis client 102 and the architectural structure analysis server 106 can be implemented as one or more processes operating on a single computer system without need of such a network as the computer network 104.

Through the architectural structure analysis client 102, a user, such as an architect, can access services, features, and functionality provided by the architectural structure analysis server 106 in accordance with some embodiments. For instance, by way of a web-based service, an application program interface (API), or a software plug-in, architectural structure design software, such as a computer-aided design (CAD) software tool, can access the architectural structure analysis services provided by the architectural structure analysis server 106. In accordance with some embodiments, the architectural structure design software may access the architectural structure analysis services as the architectural structure design software is used to design or modify a computer-implemented design model (e.g., CAD model) representing an architectural structure.

For example, consider where a computer-implemented design model representing an architectural structure is accessed and modified by a user at the architectural structure analysis client 102 using the architectural structure design software. The architectural structure analysis client 102 may provide the architectural structure analysis server 106 with design model information relating to the computer-implemented design model, as the computer-implemented design model is accessed and modified. In accordance with some embodiments, the design model information provided may describe less than the entire computer-implemented design model at the architectural structure analysis client 102. For instance, the design model information may be design model delta data that describes only one or more modifications performed to the computer-implemented design model at the architectural structure analysis client 102.

Based on the design model information provided, the architectural structure analysis server 106 can analyze the architectural structure and determine the impact of the modifications, performed to the computer-implemented design model at the architectural structure analysis client 102, on one or more predicted characteristics of the architectural structure. The architectural structure analysis server 106 can provide the architectural structure analysis client 102 with analysis data regarding the impact of the modification (i.e., impact analysis data). Using the impact analysis data, the architectural structure analysis client 102 can present the impact to the user through the architectural structure design software. The impact may, for example embodiment, be presented to the user as text-based or graphical information, which may be presented near (e.g., along-side) or overlain onto design model elements of the computer-implemented design model as visually rendered.

In this way, the impact can be presented to the user as design feedback as the user accesses and modifies the computer-implemented design model through the architectural structure design software. In particular, the user modifies the computer-implemented design model through the architectural structure design software at the architectural structure analysis client 102, and the architectural structure analysis client 102 can provide the user with design feedback based on the modification of the computer-implemented design model, as facilitated by the architectural structure analysis server 106. As one or more additional modifications are performed to the computer-implemented design model at the architectural structure analysis client 102, the architectural structure analysis client 102 can: (1) provide the architectural structure analysis server 106 with design model information describing the additional modifications; (2) the architectural structure analysis server 106 can provide architectural structure analysis client with the impact of the additional modifications to one or more predicted characteristics of the architectural structure; and (3) the architectural structure analysis client 102 can present updated design feedback caused by the additional modifications.

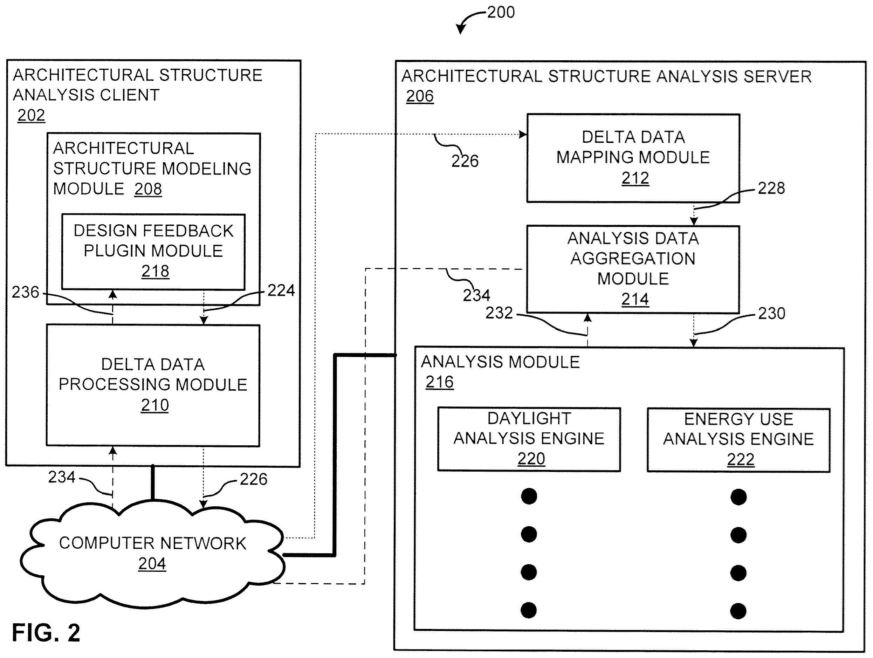

Figure 2 is a block diagram illustrating an example architectural structure analysis system in accordance with some embodiments of the technology described herein. In particular, FIG. 2 illustrates an example environment 200 that includes an architectural structure analysis client 202, an architectural structure analysis server 206, and a computer network 204 configured to facilitate data communication between the architectural structure analysis client 202 and the architectural structure analysis server 206. In accordance with some embodiments, the architectural structure analysis client 202 may be similar to the architectural structure analysis client 102 of FIG. 1, and the architectural structure analysis server 206 may be similar to the architectural structure analysis server 106.

The architectural structure analysis client 202 may be configured to: access a computer-implemented design model representing an architectural structure; modify the computer-implemented design model; provide design model delta data relating to the modification to the architectural structure analysis server 206; receive analysis data from the architectural structure analysis server 206 relating to the impact of the modifications to the architectural structure; and presenting the impact analysis data as design feedback. In the example of FIG. 2, the architectural structure analysis client 202 comprises an architectural structure modeling module 208 and a delta data processing module 210.

In the architectural structure analysis client 202, the architectural structure modeling module 208 may be configured to facilitate access, creation, or modification of a computer-implemented design model representing an architectural structure, such as a home, office building, parking structure, shopping center, or the like. The architectural structure modeling module 208 may enable a user at the architectural structure analysis client 202 to access, create, or otherwise modify the computer-implemented design model through a graphical-user interface (GUI) configured to facilitate such operations. Through the architectural structure modeling module 208, the user may view a visual rendering of the computer-implemented design model and perform modifications via the visual rendering. In some embodiments, the architectural structure modeling module 208 may be implemented in whole or in part by a computer-aided design (CAD) software, such as Google^{®} Sketch-up or Autodesk AutoCAD^{®}.

To facilitate design feedback through the architectural structure modeling module 208, the architectural structure modeling module 208 may include a design feedback plugin module 218 compatible with the architectural structure modeling module 208. Where the architectural structure modeling module 208 is implemented by CAD software (e.g., Google^{®} Sketch-up^{®}), the design feedback plugin module 218 may be one configured to be operable with the CAD software (e.g., Google^{®} Sketch-up^{®} Plug-in). The design feedback plugin module 218 may be configured to capture actions performed on the computer-implemented design model by the user using the architectural structure modeling module 208. Depending on the embodiment, the design feedback plugin module 218 may communicate a current state of the computer-implemented design model when the design feedback plugin module 218 detects modification of the computer-implemented design model through the architectural structure modeling module 208. In the event that modeling events are not triggered automatically, the design feedback plugin module 218 may monitor for modifications to the computer-implemented design model. As described herein, modification of a computer-implemented design model may include a change in the geometry, position, orientation, surface texture, color, or some other property of a design model element of the computer-implemented design model. As also described herein, design model elements may include lines, color, surface texture, face and planes in a three-dimensional space. The design elements in the computer-implemented design model may be intended to represent features of an architectural structure, such as walls, floors, windows, roofs, and fenestrations.

The design feedback plugin module 218 may further facilitate communication data between the architectural structure modeling module 208 and the architectural structure analysis server 206. As a user utilizes the architectural structure modeling module 208 to design or modify a computer-implemented design model, the design feedback plugin module 218 can output design information 224 relating to the current state of the computer-implemented design model for design feedback analysis by the architectural structure analysis server 206. The design feedback plugin module 218 may further receive analysis data relating to an impact of the current state of the computer-implemented design model on a predicted characteristic of the architectural structure, where the current state of the computer-implemented design model a modified version of the computer-implemented design model.

For some embodiments, the design feedback plugin module 218 may access the services of the architectural structure analysis server 206 by way of sign-on process. A successful sign-on may permit the architectural structure modeling module 208 to utilize the design feedback provided by the architectural structure analysis server 206.

As to avoid having to send the entire current computer-implemented design model to the architectural structure analysis server 206, the architectural structure analysis client 102 may utilize the delta data processing module 210 to receive the output design information 224 relating to the current state of the computer-implemented design model and generate, based on the output design information 224, design model delta data 226 reflecting the one or more design differences between a previous state of the computer-implemented design model (e.g., before modification through the architectural structure modeling module 208) and current state of the computer-implemented design model (e.g., after modification through the architectural structure modeling module 208). The design differences may include a change to a property of a design model element of the computer-implemented design model. The design model delta data 226 produced by the delta data processing module 210 can be provided to the architectural structure analysis server 106 to facilitate design feedback.

To illustrate example design model delta data, consider TABLE 1 below, which lists before and after design data for a computer-implemented design model representing an architectural structure.

| **TABLE 1** | |
|---|---|
| **DESIGN DATA BEFORE MODIFICATION** | **DESIGN DATA AFTER MODIFICATION** |
| { | { |
| "north_glazing_component": | "north_glazing_component": |
| 0, | 0, |
| "south_glazingcomponent": | "south_glazing_component": |
| _ 0, | 35, |
| "east_glazing_component": | "east_glazing_component": |
| 0, | 0, |
| "west_glazing_component": | "west_glazing_component": |
| 0, | 0, |
| "total_glazing_area": | "total_glazing_area": |
| 0, | 35, |
| "total_wall_area": | "total_wall area": |
| 280, | 245, |
| "total_floor_area": | "total_floor_area": |
| 100.0, | 100.0, |
| "ground_floor_area": | "ground_floor_area": |
| 100.0, | 100.0, |
| "building_height": | "building_height": |
| 7.0, | 7.0, |
| "location": | "location": |
| "NYC", | "NYC", |
| "spaceUseType": | "space Use Type": |
| "Office" | "Office" |
| } | } |

The design model delta data may comprise the following design data, reflecting the change to deign model elements between the previous state and the current state of the computer-implemented design model: { "south_glazing_component": 35, "total_glazing_area": 35, "total_wall_area": 245 }.

Additionally, to determine the change in impact on a predicted characteristic of the architectural structure as result of the current state of the computer-implemented design model, the architectural structure analysis client 202 may utilize the delta data processing module 210 may receive impact analysis data 234 from the architectural structure analysis server 206, and provide to the architectural structure modeling module 208 (e.g., through the design feedback plugin module 218) impact delta data 236 reflecting the change in impact.

By facilitating the movement of incremental information (e.g., design model delta data 226, and impact delta data 236), the delta data processing module 210 can minimize data that needs to be move to and from the modeling environment at the architectural structure analysis client 202. For some embodiments, the minimization of information improves or otherwise facilitates the architectural structure analysis client 202 receiving design feedback at or near the time changes are applied to a computer-implemented design model.

The architectural structure analysis server 206 configured to: receive from the architectural structure analysis client 102, design model delta data relating to a modification to a computer-implemented design model representing an architectural structure; analyze the impact of the modification on one or more predicted characteristics of the architectural structure; and provide analysis data relating to the impact to the architectural structure analysis client 102. In the example of FIG. 2, the architectural structure analysis server 206 comprises a delta data mapping module 212, an analysis data aggregation module 214, and an analysis model 216.

The delta data mapping module 212 may be configured to receive the design model delta data 226 from the architectural structure analysis client 102, and map (e.g., interprets) the design model delta data 226 to building delta data. The architectural structure analysis server 206 may possess building data representing the architectural structure that is represented by the computer-implemented design model at the architectural structure analysis client 202. Accordingly, the building delta data may be configured to modify the building data at the architectural structure analysis server 206 to represent the architectural structure as the architectural structure is represented by the current state of the computer-implemented design model at the architectural structure analysis client 202. In particular, the delta data mapping module 212 may parse the design model delta data 226 and combine the parsing results with the last version of the building data to produce a current version of the building data 228. The delta data mapping module 212 may provide the building data 228 to the analysis data aggregation module 214 to perform analysis on the architectural structure represented by the current version of the building data 228. By its operations, the delta data mapping module 212 may facilitate the tagging geometry data, from a computer-aided design (CAD) software tool, to building data for impact analysis, and may obviate the need for a user to perform such operations manually. Depending on the embodiment, the current version of the building data 228 may be implemented according to a standard format, such as COLLADA^{™}, which defines an XML-based schema to make it easy to transfer three-dimensional assets between computer processes.

Those skilled in the art will appreciate that in some embodiments, the architectural structure analysis server 206 may maintain a local version of the computer-implemented design model, utilize the design model delta data 226 to modify the local version of the computer-implemented design model at the architectural structure analysis server 206, and map the resulting modified version of the computer-implemented design model to the building data 228. Those skilled in the art will also appreciate that other methods of delivering geometry data (e.g., of the computer-implemented design model)from the architectural structure analysis client 202 to the architectural structure analysis server 206, or mapping the geometry data to building data may exist in some embodiments.

In some embodiments, the delta data mapping module 212 may be configured to map design data to building delta data in accordance with one or more rules that define such mapping. For various embodiments, the architectural structure analysis server 206 may comprise a set of default rules determining the behavior of the delta data mapping module 212. For certain embodiments, one or more of rules (e.g., default rules) may be overridden by a user-defined rule. A given rule may or may not define whether a user-defined rule may override the definition of the given rule.

Table 2 below provides some example rules configured to determine the behavior of the delta data mapping module 212. As these rules are merely examples, those skilled in the art will appreciate that in some embodiments, the rules may be different in number and definition from the rules provided below.

| | **TABLE 2** | |
|---|---|---|
| | **RULE** | **SPECIFICS** |
| | | |
| **1** | Material Transparency Consistency Rule | A face with no material attached or with Rule material of 1.0 alpha value will be recognized as "Wall" or "Roof Candidates" |
| | | A face with no material attached or with material of alpha value less than 1.0 will be recognized as "Window" or "SkyLight Candidates" |
| | | One cannot override a "Transparent Window" into "Non-Transparent Wall," or vice versa. |
| | | A face with material attached will only have front material mapped. |
| **2** | Tilt Angle Consistency Rule | "Tilt Angle" is defined as the angle formed between any line on a face that does not parallel to the X-Y plane with the X-Y plane; tilt angle can range [0, 180] degree. |
| | | If the Tile Angle of a face is: (1) <= 10 degree or >= 170 degree, the face is recognized as a "Floor Candidate"; (2) > 10 degrees but < 30 degrees, or > 150 degrees but < 170 degrees; or (3) > 10 degrees but < 30 degrees, the face is recognized as a "Roof' or "Skylight Candidate". |
| | | If the Tile Angle of a face is >= 150 degrees but >= 30 degrees, the face is recognized as a "Window" or "Wall Candidate". |
| | | If the Tile Angle of a face is: (1) 0 or 180 degrees, it can never be overridden as a Winnow or Wall; and (2) 90 degrees, it a Window or Wall and cannot be overridden to be otherwise. |
| | | If the Tile Angle of a face is a "Floor Candidate" it can never be set to a Floor via overriding. |
| **3** | Touching Ground Rule | No Footprint and No Floor Areas will be reported unless a design model touches or stride through Z=0 ground plane; or a Sloping Ground Plane is defined. |
| | | No Massing will be reported if a building is completely above ground or below ground by more than 50 cm margin. |
| **4** | Below Ground Rule | An Underground Structure is treated the same as being above ground. Accordingly, if a user draws a window at below ground, it will still be recognized as window. |
| **5** | Floor #1 Always at Z=0 | If a building has below-ground structure, it could have below ground floor(s) numbered as -1, -2, ....; but Floor #1 is always at Z=0. |
| **6** | Default Calculated Floor(s) Must Meet Overhead Floor-to-Ceiling Height. In case of Uneven Ceiling, the aggregate covering area of ceiling(s) that are within 3.5 meter of the Floor must be no more than 50% of the covered Floor Area. | In the absence of recognized user-added floor(s), all floors must have a minimum default floor-to-floor height of 3.5 meter. |
| **7** | Window Must be Drawn and cannot be left hollow. No Window, No Glazing, No Glazing Ratio, possibly no Floor(s). | |
| **8** | Hidden Design model elements will not be Recognized | |
| **9** | Mapping will Bail out Early on Excessive Complexity | If the density of plane count exceed an aggregate average of 10 plane per inch of building height, the mapping will bail out and no further output will be produced. |
| | | For example, a building with 5 meter height, approximately 200 inches, when the plane # count reaches 2,000, the parsing will stop. Think about it, 2000 planes for a Flat. |
| **10** | Until the internal structure is identified, the mapping will operate under the assumption of "No Internal Plane". | "Internal Planes" are defined as internal building structures that cannot been seen from any point beyond building bounding box except perhaps their edges or vertices if all windows were opaque", shall NOT be present in the model (except in the case a User-Added Floor) |
| | | Internal Planes can affect accuracy of floor area calculation, adding more area or remove some/all area. |
| **11** | All "Intersecting Faces" in the design model must be made to be "Physically Intersecting" via "Intersecting Faces" property. | |
| **12** | A User-Placed Floor (or User-Added Floor) is defined as "Floor Candidate" Plane which is strictly "Internal" Plane, except when an Non-Internal "Floor Candidate" is overridden as "Floor" (when it will be regarded as "User-Placed Floor") | |
| **13A** | Overhanging Floor becomes a Floor | The plane as the bottom of an overhang structural feature is NOT recognized as a floor, unless its floor area is > 90% of the cross section area of the building at the same height. |
| **13B** | Overhanging Floor becomes a Floor | The plane as the bottom of an overhang structural feature is recognized as a floor: (1) when a user explicitly places a floor plane inside this bottom plane of the overhand structural feature, and (2) if the aggregate area of both overhanging bottom and inside floor is > 30% of the cross section area of the building at the same height. |
| **13C** | Overhanging Floor becomes a Floor | The plane as the bottom of an overhang structural feature is recognized as a floor: (1) when a user explicitly places a floor plane inside this bottom plane of the overhand structural feature, but (2) the user-added floor plane is not large and does not cover the entire part of the supposed floor, if the aggregate area of both overhanging bottom and inside floor is > 30% of the cross section area of the building at the same height. |
| **13D** | Overhanging Floor becomes a Floor | The plane as the top of an overhang structural feature is NOT recognized as a floor, regardless if there is an explicitly-placed floor plane at the same level by a user. |
| **13E** | Overhanging Floor becomes a Floor | The plane as the bottom of an overhang structural feature is recognized as a floor: when it is big enough, reaching 90% of the area of a supposed floor plane at this Z level, it IS recognized as a floor plane. |
| **14** | Only Detect One User-Added Floor When Setting a Floor as Precedent to Default floor(s) | |
| **15A** | Shading and Overhang Recognition | **External Building Planes:** planes (1) that do not intersect with building floors if such a floor exists, (2) that exist at the same Z-level or range as other "external planes", or (3) that intersects at no more than a few points and never intersect with building floors to form any line, and (4) cannot be seen from any point of a building floor if all window were opaque. |
| **15B** | Shading and Overhang Recognition | **Pure Shading (in short, Shading):** external building planes that do not form any enclosing space/volume with themselves or with other building planes |
| **15C** | Shading and Overhang Recognition | **Overhang:** external building planes that form enclosing space/volume that is however non-livable due to limited head space or floor space |

The analysis data aggregation module 214 may be configured to receive the current version of the building data 228, and send some or all of the building data 230 to one or more analysis engines of the analysis module 216, which may be configured to analyze the architectural structure based on the building data 230 it receives. By sending some or all of the building data 230 to various analysis engines, analysis data aggregation module 214 may delegate/distribute the analysis workload for the architectural structure and perform different types of analysis in parallel. The various analysis engines of the may be implemented using cloud-based resources and may utilize queuing mechanisms built into such resources.

As shown in FIG. 2, the analysis module 216 may comprise a daylight analysis engine 220 configured to provide analyzing the potential amount of daylight the architectural will receive based on some or all of the building data 230. The analysis module 216 may also comprise an energy use analysis engine 222 configured to determine the predicted energy use of the architectural structure based on some or all of the building data 230. Results 232 of the analysis may be returned to the analysis data aggregation module 214, which may aggregate the results and coalesce the results to produce the impact analysis data 234 for the architectural structure analysis client 202. For some embodiments, the results 232 may be integrated results, combining results regarding multiple characteristics of the architectural structure (e.g., daylighting, energy use, water use, etc.), possibly without manual selection by a user. As described herein in further detail, the impact analysis data 234 may relate to an impact on a predicted characteristic of the architectural structure based on the modification performed at the architectural structure analysis client 202, which resulted in the current state of the computer-implemented design model and the output design information 224 related thereto. When performing analysis of an architectural structure, the analysis module 216 may take into consideration various settings provided by the user at the architectural structure analysis client 202 include, for example, the use type of the architectural structure (e.g., residence, business, hospital, etc.) and the intended geographic location for architectural structure (e.g., city, state, country, continent, elevation latitude and longitude, etc.). Based on the settings, the analysis module 216 may obtain or utilize geography related data (e.g., weather, temperature, rainfall, resource availability) in its analysis of the architectural structure.

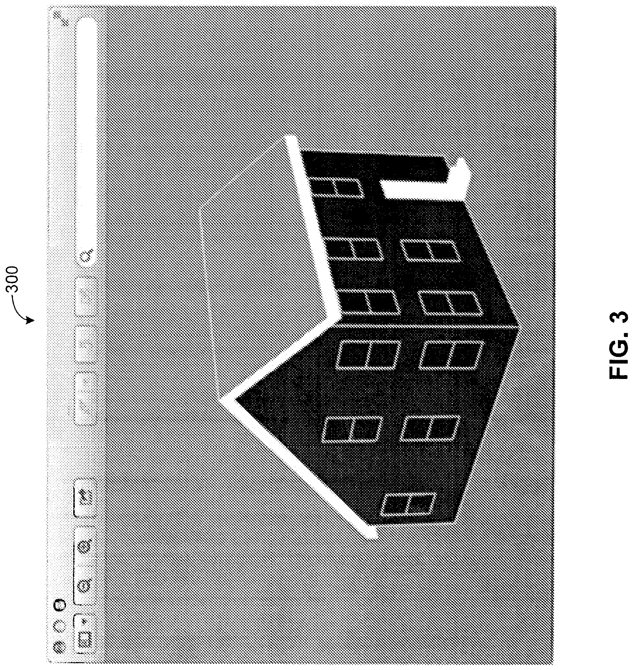

FIG. 3 provides a visual rendering 300 of an example computer-implemented design model representing an example architectural structure in accordance with some embodiments of the technology disclosed herein. As described herein, the architectural structure modeling module 208 may access and visually present the visual rendering 300 to a user for the user to modify various design model elements of the architectural structure represented.

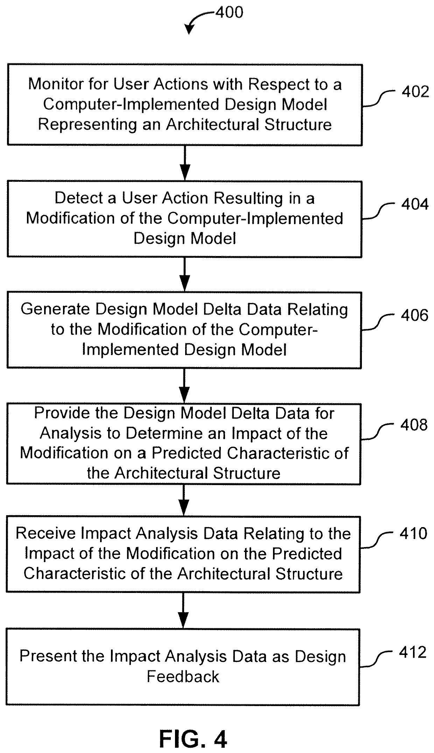

Figure 4 a flowchart illustrating an example method 400 for analyzing an architectural structure in accordance with some embodiments of the technology disclosed herein. According to some embodiments, the method 400 may be one performed by the architectural structure analysis client 202 as user accesses a computer-implemented design model through the architectural structure analysis client 202.

As shown in FIG. 4, the method 400 may begin at operation 402 with user actions being monitored with respect to a computer-implemented design model representing an architectural structure. For instance, the design feedback plugin module 218 may monitor user actions with respect a computer-implemented design model being access by a user through the architectural structure modeling module 208.

At operation 404, a user action may be detected where the detected user action results in a modification of the computer-implemented design model. For example, the design feedback plugin module 218 may detect when a user action results in a modification of a computer-implemented design model being access by a user through the architectural structure modeling module 208, thereby resulting in the current state of the computer-implemented design model.

Subsequently, at operation 406, design model delta data may be generated relating to the modification of the computer-implemented design model. In one example, the delta data processing module 210 may generate design model delta data from the current state of computer-implemented design model, which may be modified in comparison to the previous state of the computer-implemented design model. At operation 408, the design model delta data generated at operation 406 may be provided for analysis to determine an impact of the modification on a predicted characteristic of the architectural structure. For instance, the delta data processing module 210 may provide design model delta data to the architectural structure analysis server 206 for impact analysis on the predicted characteristic of the architectural structure.

Eventually, at operation 410, impact analysis data may be received relating to the impact of the modification on the predicted characteristic of the architectural structure. For instance, the architectural structure analysis client 202 may receive the impact analysis data from the architectural structure analysis server 206 in response to the delta data processing module 210 providing the design model delta data to the architectural structure analysis server 206. The impact analysis data can be presented as design feedback at operation 412. In some examples, the design feedback plugin module 218 may be present the impact analysis data as design feedback at or near the computer-implemented design model being accessed through the architectural structure modeling module 208.

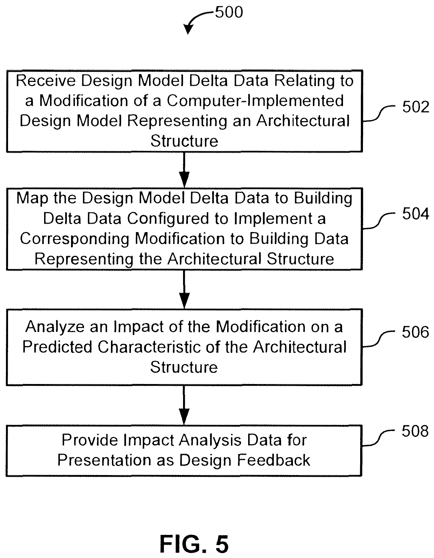

Figure 5 a flowchart illustrating an example method 500 for analyzing an architectural structure in accordance with some embodiments of the technology disclosed herein. According to some embodiments, the method 500 may be one performed by the architectural structure analysis server 206 as user accesses a computer-implemented design model at the architectural structure analysis client 202, and the architectural structure analysis client 202 provides data relating to the modifications performed to a computer-implemented design model to the architectural structure analysis server 206.

As shown in FIG. 5, the method 500 may begin at operation 502 with design model delta data being received, where the design model delta data relates to a modification of a computer-implemented design model representing an architectural structure.

At operation 504, the design model delta data may be mapped to building delta data configured to implement a corresponding modification to building data representing the architectural structure. For example, the delta data mapping module 212 may map design model delta data received from the architectural structure analysis client 102 to building data.

At operation 506, an impact of the modification on a predicted characteristic of the architectural structure may be analyzed. In one example, the analysis data aggregation module 214 and the analysis module 216 may receive the building data produced based on the building delta data and analyze the architectural structure represented by the building data.

At operation 508, impact analysis data may be provided for presentation as design feedback. In an example, the analysis data aggregation module 214 and the analysis module 216 may provide impact analysis data to the architectural structure analysis client 202, which may present the impact analysis data as design feedback.

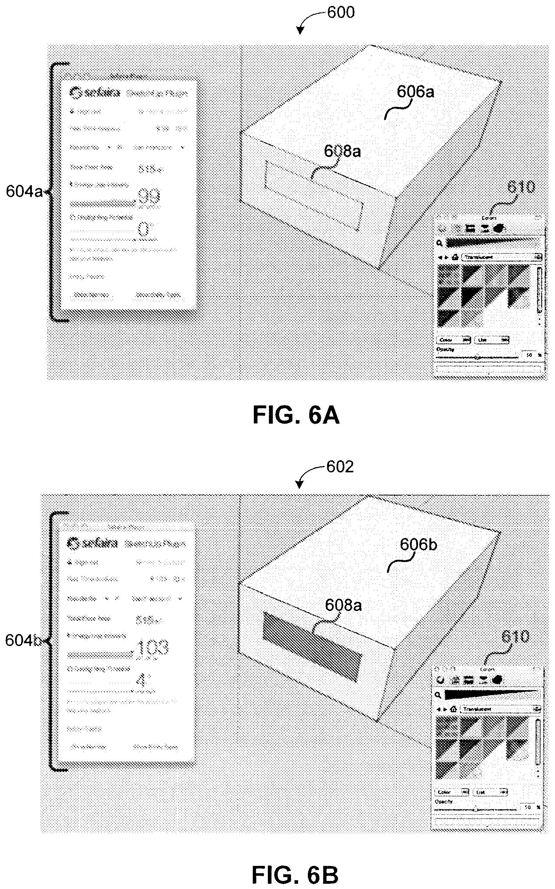

Figures 6A and 6B provide screenshots 600 and 602 illustrating design feedback during design a computer-implemented design model representing an example architectural structure in accordance with some embodiments of the technology disclosed herein. In particular, the screenshots 600 and 602 may be of an example graphical-user interface (GUI) of an example CAD software accessing the computer-implemented design model.

In screenshot 600, a computer-implemented design model 606a, having a non-textured design model element 608a, is visually rendered. Near the visually rendering of the computer-implemented design model 606a, a plugin GUI panel 604a is presented, which may be configured to present design feedback for the current configuration of the computer-implemented design model 606a (e.g., energy usage at 99 kBTU/ft2/yr, 0% of the interior area that is lit by daylight). In screenshot 602, the non-textured design model element 608a of computer-implemented design model 606a is modified to be a textured design model element 608b of a computer-implemented design model 606b (e.g., where the texture represents a window, causing energy usage to be 103 kBTU/ft2/yr and 4% of the interior area being lit by daylight). As a result of the modification, a plugin GUI panel 604b presents the updated design feedback reflecting the configuration of the computer-implemented design model 606b. According to some embodiments, a texture GUI panel 610 can facilitate changing the surface texture of various design model elements of computer-implemented design models.

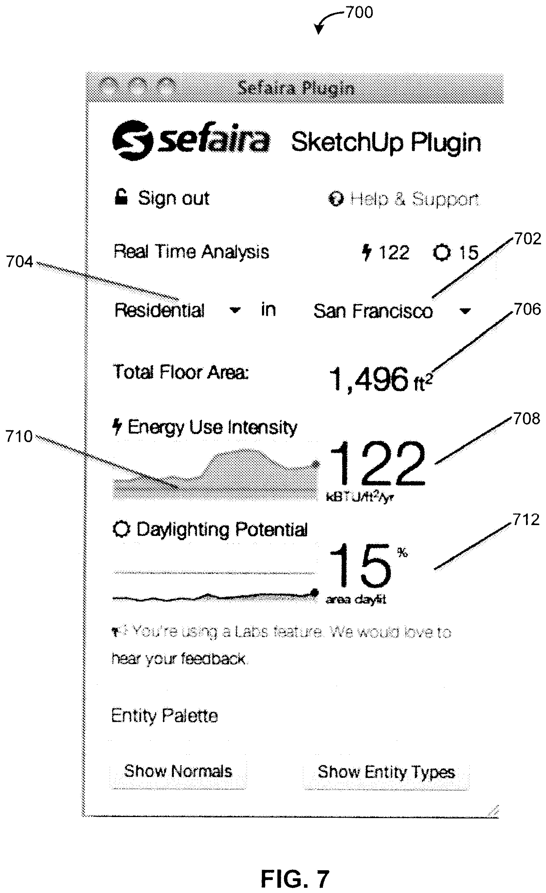

Figure 7 provides a screenshot 700 of an example graphical-user interface (GUI) panel for architectural structure analysis in accordance with some embodiments of the technology disclosed herein. In particular, the screenshot 700 may be of an example graphical-user interface (GUI) panel presented through an example CAD software accessing the computer-implemented design model. According to some embodiments, the GUI panel of FIG. 7 may provide for features that enable a user at a CAD software tool to sign-on to the design feedback services provided by an architectural structure analysis server. The GUI panel of FIG. 7 may further provide for control of the design feedback feature, and presentation of design feedback. For example, through the GUI panel of FIG. 7, a user can view and change the intended geographic location 702 of the architecture structure represented by the current computer-implemented design model. Additionally, a user may view and change the intended use type 704 of the architecture structure represented by the current computer-implemented design model. The GUI panel of FIG. 7 may present various characteristics of the architectural structure represented by the current computer-implemented design model including, for example, square footage 706 of the architecture structure, energy use 708 by the architectural structure, and area 712 of the architecture structure that is lit by daylight. A benchmark indicator 710 may graphically present a benchmark trying to be attained for the architectural structure. The benchmark indicator 710 may be according to a standard, certification or rating, including such green building certification and rating systems as Leadership in Energy & Environmental Design (LEED^{®}) and Code for Sustainable Homes (CSH), and Building Research Establishment Environment Assessment Method (BREEAM).

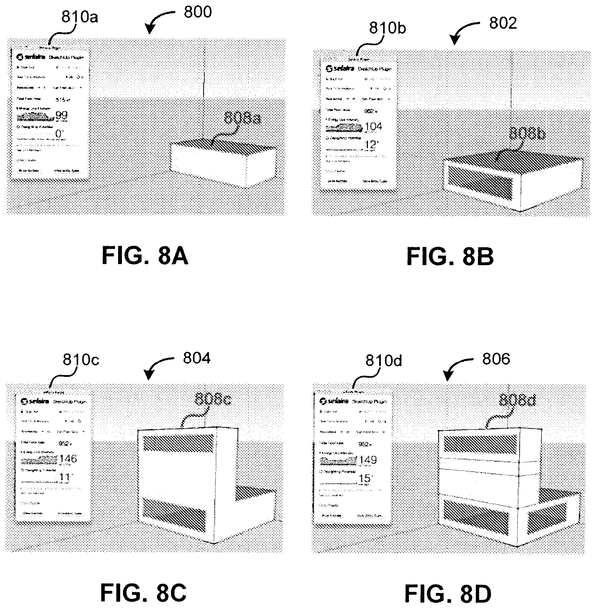

Figures 8A-8D provide screenshots 800, 802, 804, and 806 illustrating design feedback during design of a computer-implemented design model representing an example architectural structure in accordance with some embodiments of the technology disclosed herein. In particular, the screenshots 800, 802, 804, and 806 may be of an example graphical-user interface (GUI) of an example CAD software accessing the computer-implemented design model. The screenshots 800, 802, 804, and 806 illustrate how modifications to the computer-implemented design model 808a over multiple iterations (e.g., 808b, 808c, and 808d) can cause design feedback being provided through the GUI panel 810a to change after each iteration (e.g., 810b, 810c, and 810d).

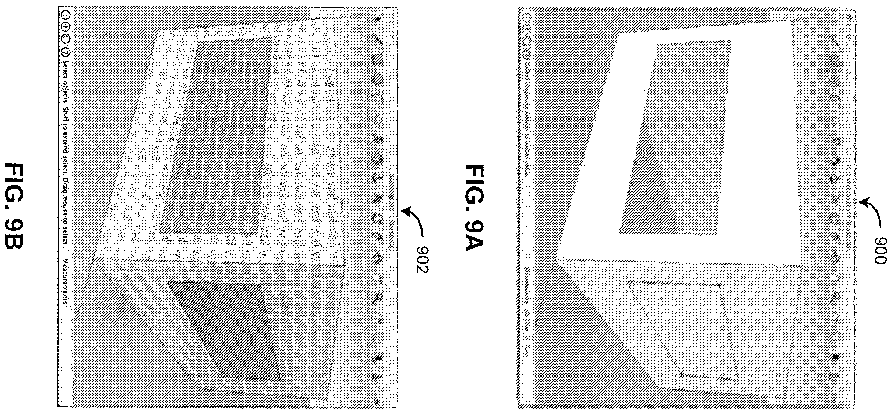

Figures 9A and 9B provide screenshots 900 and 902 illustrating an example of modifying a computer-implemented design model representing an example architectural structure in accordance with some embodiments of the technology disclosed herein. In particular, the screenshots 900 and 902 may be of an example graphical-user interface (GUI) of an example CAD software accessing the computer-implemented design model. In screenshot 900, the computer-implemented design model is presented as visually rendered. In screenshot 902, the same the computer-implemented design model is also presented visually rendered with the entity of each design model elements being shown. As used herein, an "entity" may identify building elements represented by design model elements in a computer-implemented design model. Examples of entities can include, without limitation, glazing, walls, roofs, floors, internals walls, and party walls. In some embodiments, the visual feedback may include information regarding the entity of each design model element, as automatically identified/recognized by an architectural structure analysis server (e.g., according to the rules that determine the behavior of the delta data mapping module 212). In some embodiments, the entity can be overridden by user action through the CAD software accessing the computer-implemented design model.

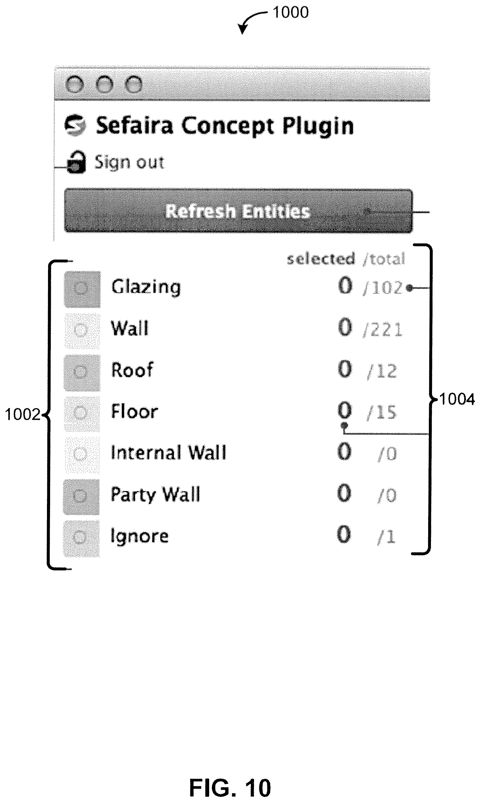

Figure 10 provides a screenshot 1000 of an example graphical-user interface (GUI) panel for modifying a computer-implemented design model representing an example architectural structure in accordance with some embodiments of the technology disclosed herein. In particular, the screenshot 1000 may be of an example graphical-user interface (GUI) panel presented through an example CAD software accessing the computer-implemented design model. As shown, the GUI panel of FIG. 10 lists the various entity categories 1002 can exist for a current computer-implemented design model, and list the number 1004 of such entities presented in the current computer-implemented design model. For some embodiments, the GUI panel of FIG. 10 may facilitate controlling how certain design model elements are identified as entities.

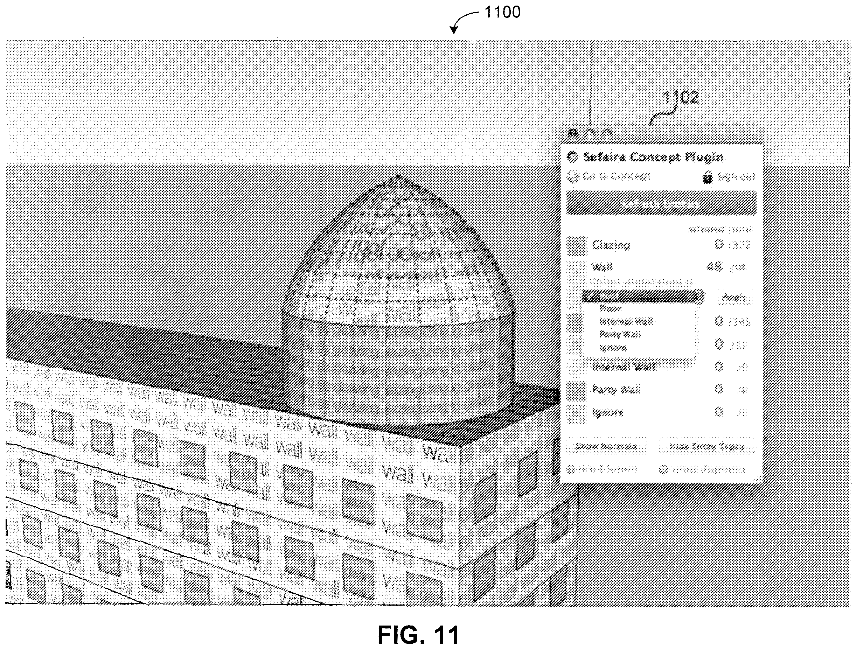

Figure 11 provides a screenshot 1100 illustrating an example of modifying a computer-implemented design model representing an example architectural structure in accordance with some embodiments of the technology disclosed herein. In particular, the screenshot 1100 may be of an example graphical-user interface (GUI) of an example CAD software accessing the computer-implemented design model. In screenshot 1100, a GUI panel 1102 is presented as facilitating an override of the identified entity of a selected design model element.

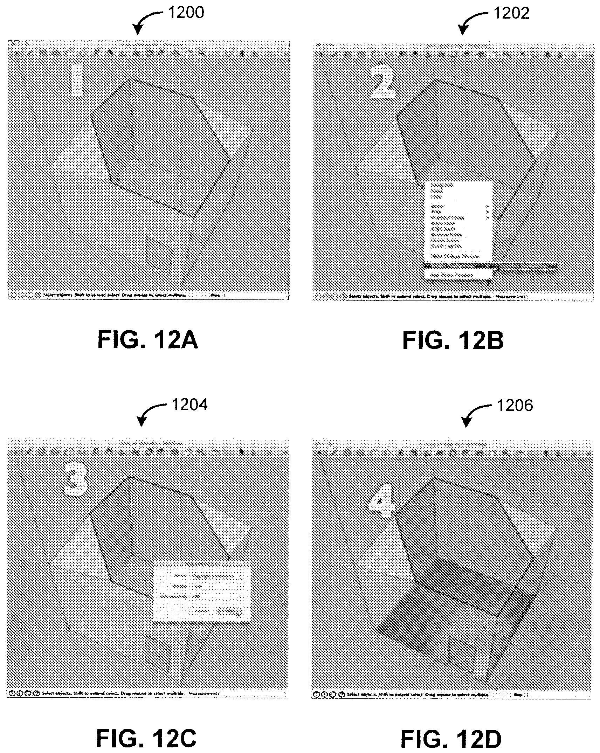

Figures 12A-12D provide screenshots 1200, 1202, 1204, and 1206 illustrating visual design feedback during design of a computer-implemented design model representing an example architectural structure in accordance with some embodiments of the technology disclosed herein. In particular, the screenshots 1200, 1202, 1204, and 1206 may be of an example graphical-user interface (GUI) of an example CAD software accessing the computer-implemented design model. Screenshots 1200, 1202, 1204, and 1206 illustrate how a user selects a plane (e.g., a floor) and selects to view a daylighting factor heat map as design feedback based of the current computer-implemented design model. As shown, the selection of the daylighting factor heat map can be mapped to the visual rendering of the current computer-implemented design model. In accordance with some embodiments, any subsequent modification to the computer-implemented design model may result in the daylighting factor heat map changing.

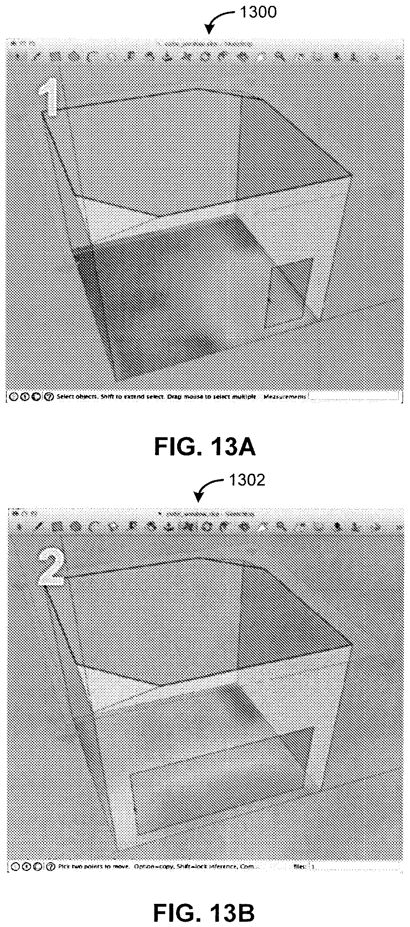

Figures 13A and 13B provide screenshots 1300 and 1302 illustrating visual design feedback during design of a computer-implemented design model representing an example architectural structure in accordance with some embodiments of the technology disclosed herein. In particular, the screenshots 1300 and 1302 may be of an example graphical-user interface (GUI) of an example CAD software accessing the computer-implemented design model. Screenshots 1300 and 1302 illustrate how a daylighting factor heat map is being presented as design feedback with respect to the computer-implemented design model, and how the daylighting factor heat map is affected when a user, for example, selects an edge of a design model element representing a window and expands it horizontally. In accordance with various embodiments, after the window is increased in size, a new architecture structure analysis is triggered for the current computer-implemented design model having the modified design model element (e.g., window), and the daylighting factor heat map is updated accordingly.

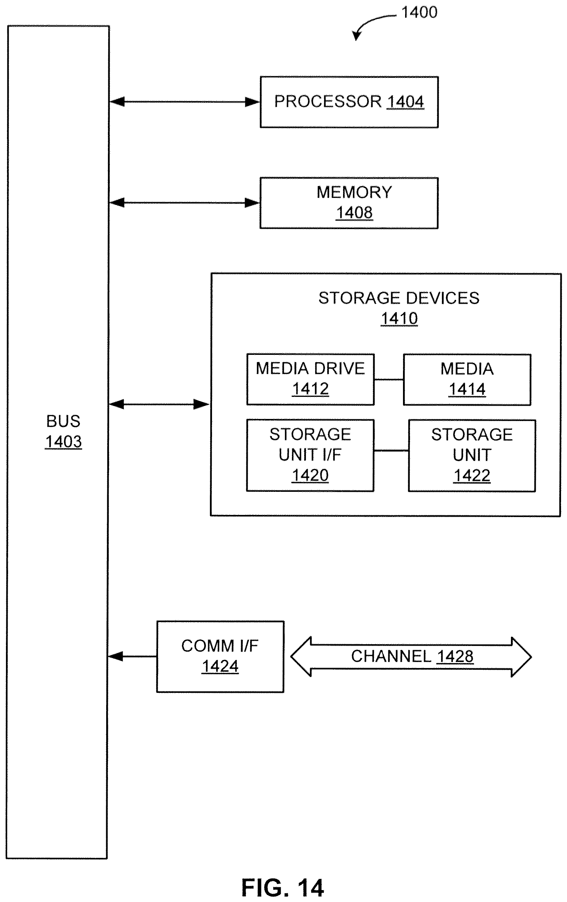

Where components or modules of the technology are implemented in whole or in part using software, in one embodiment, these software elements can be implemented to operate with a computing or processing module capable of carrying out the functionality described with respect thereto. One such example computing module is shown in FIG. 14. Various embodiments are described in terms of this example-computing module 1400. After reading this description, it will become apparent to a person skilled in the relevant art how to implement the technology using other computing modules or architectures.

Referring now to FIG. 14, computing module 1400 may represent, for example, computing or processing capabilities found within desktop, laptop and notebook computers; hand-held computing devices (PDA's, smart phones, cell phones, palmtops, etc.); mainframes, supercomputers, workstations or servers; or any other type of special-purpose or general-purpose computing devices as may be desirable or appropriate for a given application or environment. Computing module 1400 might also represent computing capabilities embedded within or otherwise available to a given device. For example, a computing module might be found in other electronic devices such as, for example, digital cameras, navigation systems, cellular telephones, portable computing devices, modems, routers, WAPs, terminals and other electronic devices that might include some form of processing capability.

Computing module 1400 might include, for example, one or more processors, controllers, control modules, or other processing devices, such as a processor 1404. Processor 1404 might be implemented using a general-purpose or special-purpose processing engine such as, for example, a microprocessor, controller, or other control logic. In the illustrated example, processor 1404 is connected to a bus 1402, although any communication medium can be used to facilitate interaction with other components of computing module 1400 or to communicate externally.

Computing module 1400 might also include one or more memory modules, simply referred to herein as main memory 1408. For example, preferably random access memory (RAM) or other dynamic memory, might be used for storing information and instructions to be executed by processor 1404. Main memory 1408 might also be used for storing temporary variables or other intermediate information during execution of instructions to be executed by processor 1404. Computing module 1400 might likewise include a read only memory ("ROM") or other static storage device coupled to bus 1402 for storing static information and instructions for processor 1404.

The computing module 1400 might also include one or more various forms of information storage mechanism 1410, which might include, for example, a media drive 1412 and a storage unit interface 1420. The media drive 1412 might include a drive or other mechanism to support fixed or removable storage media 1414. For example, a hard disk drive, a floppy disk drive, a magnetic tape drive, an optical disk drive, a CD or DVD drive (R or RW), or other removable or fixed media drive might be provided. Accordingly, storage media 1414 might include, for example, a hard disk, a floppy disk, magnetic tape, cartridge, optical disk, a CD or DVD, or other fixed or removable medium that is read by, written to or accessed by media drive 1412. As these examples illustrate, the storage media 1414 can include a computer usable storage medium having stored therein computer software or data.

In alternative embodiments, information storage mechanism 1410 might include other similar instrumentalities for allowing computer programs or other instructions or data to be loaded into computing module 1400. Such instrumentalities might include, for example, a fixed or removable storage unit 1422 and an interface 1420. Examples of such storage units 1422 and interfaces 1420 can include a program cartridge and cartridge interface, a removable memory (for example, a flash memory or other removable memory module) and memory slot, a PCMCIA slot and card, and other fixed or removable storage units 1422 and interfaces 1420 that allow software and data to be transferred from the storage unit 1422 to computing module 1400.

Computing module 1400 might also include a communications interface 1424. Communications interface 1424 might be used to allow software and data to be transferred between computing module 1400 and external devices. Examples of communications interface 1424 might include a modem or softmodem, a network interface (such as an Ethernet, network interface card, WiMedia, IEEE 802.XX or other interface), a communications port (such as for example, a USB port, IR port, RS232 port Bluetooth^{®} interface, or other port), or other communications interface. Software and data transferred via communications interface 1424 might typically be carried on signals, which can be electronic, electromagnetic (which includes optical) or other signals capable of being exchanged by a given communications interface 1424. These signals might be provided to communications interface 1424 via a channel 1428. This channel 1428 might carry signals and might be implemented using a wired or wireless communication medium. Some examples of a channel might include a phone line, a cellular link, an RF link, an optical link, a network interface, a local or wide area network, and other wired or wireless communications channels.

In this document, the terms "computer program medium" and "computer usable medium" are used to generally refer to media such as, for example, memory 1408, storage unit 1420, media 1414, and channel 1428. These and other various forms of computer program media or computer usable media may be involved in carrying one or more sequences of one or more instructions to a processing device for execution. Such instructions embodied on the medium, are generally referred to as "computer program code" or a "computer program product" (which may be grouped in the form of computer programs or other groupings). When executed, such instructions might enable the computing module 1400 to perform features or functions of the disclosed technology as discussed herein.

While various embodiments of the disclosed technology have been described above, it should be understood that they have been presented by way of example only, and not of limitation. Likewise, the various diagrams may depict an example architectural or other configuration for the disclosed technology, which is done to aid in understanding the features and functionality that can be included in the disclosed technology. The disclosed technology is not restricted to the illustrated example architectures or configurations, but the desired features can be implemented using a variety of alternative architectures and configurations. Indeed, it will be apparent to one of skill in the art how alternative functional, logical or physical partitioning and configurations can be implemented to implement the desired features of the technology disclosed herein. Also, a multitude of different constituent module names other than those depicted herein can be applied to the various partitions. Additionally, with regard to flow diagrams, operational descriptions and method claims, the order in which the steps are presented herein shall not mandate that various embodiments be implemented to perform the recited functionality in the same order unless the context dictates otherwise.

Although the disclosed technology is described above in terms of various exemplary embodiments and implementations, it should be understood that the various features, aspects and functionality described in one or more of the individual embodiments are not limited in their applicability to the particular embodiment with which they are described, but instead can be applied, alone or in various combinations, to one or more of the other embodiments of the disclosed technology, whether or not such embodiments are described and whether or not such features are presented as being a part of a described embodiment. Thus, the breadth and scope of the technology disclosed herein should not be limited by any of the above-described exemplary embodiments.

Terms and phrases used in this document, and variations thereof, unless otherwise expressly stated, should be construed as open ended as opposed to limiting. As examples of the foregoing: the term "including" should be read as meaning "including, without limitation" or the like; the term "example" is used to provide exemplary instances of the item in discussion, not an exhaustive or limiting list thereof; the terms "a" or "an" should be read as meaning "at least one," "one or more" or the like; and adjectives such as "conventional," "traditional," "normal," "standard," "known" and terms of similar meaning should not be construed as limiting the item described to a given time period or to an item available as of a given time, but instead should be read to encompass conventional, traditional, normal, or standard technologies that may be available or known now or at any time in the future.

The presence of broadening words and phrases such as "one or more," "at least," "but not limited to" or other like phrases in some instances shall not be read to mean that the narrower case is intended or required in instances where such broadening phrases may be absent. The use of the term "module" does not imply that the components or functionality described or claimed as part of the module are all configured in a common package. Indeed, any or all of the various components of a module, whether control logic or other components, can be combined in a single package or separately maintained and can further be distributed in multiple groupings or packages or across multiple locations.

Additionally, the various embodiments set forth herein are described in terms of exemplary block diagrams, flow charts and other illustrations. As will become apparent to one of ordinary skill in the art after reading this document, the illustrated embodiments and their various alternatives can be implemented without confinement to the illustrated examples. For example, block diagrams and their accompanying description should not be construed as mandating a particular architecture or configuration.

## Claims

1. A computer-implemented method for analyzing an architectural structure, comprising:
a server computer system (206) possessing a first computer-implemented design model (208), the first computer implemented design model comprising first design model elements representing an architectural structure in a first configuration, the first design model elements comprising structural elements comprising walls, floors, roofs, ceilings or fenestrations; thereafter
the server computer system receiving design model delta data from a client computer system (202), the design model delta data describing a design difference between the first computer-implemented design model, and a second computer-implemented design model, the second computer-implemented design model comprising second design model elements representing the architectural structure in a second configuration, the second computer-implemented design model elements comprising structural elements comprising walls, floors, roofs, ceilings or fenestrations, wherein the second computer-implemented design model results from a modification comprising an addition, removal, or adjustment to the architectural structure that is performed on the first design model elements by a user using a computer-aided design (CAD) software tool at the client computer system, and wherein the design model delta data comprises information that describes less than either the first computer-implemented design model or the second computer-implemented design model;
the server computer system producing building data, based on both the first computer-implemented design model and the design model delta data, wherein the building data describes features of the architectural structure including at least one of walls, floors, roofs, ceilings, or fenestrations in the second configuration;
the server computer system analyzing, based on the building data, an impact of the modification on a predicted characteristic of the architectural structure, thereby producing impact analysis data, wherein the predicted characteristic of the architectural structure includes at least one of energy consumption by the architectural structure, water consumption by the architectural structure, fuel consumption by the architectural structure, available daylighting, a thermal characteristic of the architectural structure, compliance of the architectural structure with a construction standard, carbon footprint of the architectural structure, indoor environment quality of the architectural structure, equipment utilization by the architectural structure, a construction cost of the architectural structure, an operational cost of the architectural structure, or a maintenance cost of the architectural structure; and
the server computer system providing the impact analysis data for presentation at the client computer system as design feedback.

2. The method of claim 1, wherein producing building data comprises:
the server computer system mapping the design model delta data to building delta data configured to modify first building data, representing the architectural structure in the first configuration, to second building data, representing the architectural structure in the second configuration; and
the server computer system producing the building data based on the building delta data and previous building data representing the architectural structure in the first configuration.

3. The method of claim 2, wherein analyzing the impact of the modification further comprises:
the server computer system analyzing the predicted characteristic of the architectural structure in the first configuration based on the previous building data, thereby producing first analysis data;
the server computer system analyzing the predicted characteristic of the architectural structure in the second configuration based on the building data, thereby producing second analysis data; and
the server computer system comparing the first analysis data to the second analysis data to determine the impact of the modification to the predicted characteristic of the architectural structure.

4. The method of claim 1, wherein analyzing the impact of the modification further comprises the server computer system identifying the predicted characteristic impacted by the modification.

5. The method of claim 1, wherein analyzing the impact of the modification further comprises the server computer system determining a value representing the impact on the predicted characteristic.

6. The method of claim 1, further comprising:
the client computer system receiving the impact analysis data; and
the client computer system presenting the impact analysis as the design feedback.

7. The method of claim 6,
wherein producing building data comprises:
the server computer system mapping the design model delta data to building delta data configured to modify first building data, representing the architectural structure in the first configuration, to second building data, representing the architectural structure in the second configuration; and
the server computer system producing the building data based on the building delta data and previous building data representing the architectural structure in the first configuration.

8. The method of claim 7,
wherein analyzing the impact of the modification further comprises:
the server computer system analyzing the predicted characteristic of the architectural structure in the first configuration based on the previous building data, thereby producing first analysis data;
the server computer system analyzing the predicted characteristic of the architectural structure in the second configuration based on the building data, thereby producing second analysis data; and
the server computer system comparing the first analysis data to the second analysis data to determine the impact of the modification to the predicted characteristic of the architectural structure.

9. The method of claim 6,
wherein analyzing the impact of the modification further comprises the server computer system identifying the predicted characteristic impacted by the modification.

10. The method of claim 6,
wherein analyzing the impact of the modification further comprises the server computer system determining a value representing the impact on the predicted characteristic.

11. A server computer system comprising: at least one processor; and a memory storing instructions configured to instruct the at least one processor to perform: using a server computer system (206) which possesses a first computer-implemented design model (208), the first computer implemented design model comprising first design model elements representing an architectural structure in a first configuration, the first design model elements structural elements comprising walls, floors, roofs, ceilings or fenestrations; receiving, at the server computer system, design model delta data from a client computer system (202), the design model delta data describing a design difference between the first computer-implemented design model and a second computer-implemented design models the second computer-implemented design model comprising second design model elements representing the architectural structure in a second configuration, the second computer-implemented design model elements comprising structural elements comprising walls, floors, roofs, ceilings or fenestrations, wherein the second computer-implemented design model results from a modification comprising an addition, removal, or adjustment to the architectural structure that is performed on the first design model elements by a user using a computer-aided design (CAD) software tool at the client computer system, and wherein the design model delta data comprises information that describes less than either the first computer-implemented design model or the second computer-implemented design model; producing building data, based on both the first computer-implemented design model and the design model delta data, wherein the building data describes features of the architectural structure including at least one of walls, floors, roofs, ceilings, or fenestrations in the second configuration; analyzing, based on the building data, an impact of the modification on a predicted characteristic of the architectural structure, thereby producing impact analysis data, wherein the predicted characteristic of the architectural structure includes at least one of energy consumption by the architectural structure, water consumption by the architectural structure, fuel consumption by the architectural structure, available daylighting, a thermal characteristic of the architectural structure, compliance of the architectural structure with a construction standard, carbon footprint of the architectural structure, indoor environment quality of the architectural structure, equipment utilization by the architectural structure, a construction cost of the architectural structure, an operational cost of the architectural structure, or a maintenance cost of the architectural structure; and providing the impact analysis data for presentation at the client computer system as design feedback.

## Patentansprüche

1. Computer-implementiertes Verfahren zum Analysieren einer architektonischen Struktur, umfassend:
ein Server-Computersystem (206), das ein erstes computerimplementiertes Entwurfsmodell (208) besitzt, wobei das erste computerimplementierte Entwurfsmodell erste Entwurfsmodellelemente umfasst, die eine architektonische Struktur in einer ersten Konfiguration darstellen, wobei die ersten Entwurfsmodellelemente Strukturelemente umfassen, die Wände, Böden, Dächer, Decken oder Fensteröffnungen umfassen; wobei danach
das Server-Computersystem Entwurfsmodell-Deltadaten von einem Client-Computersystem (202) empfängt, wobei die Entwurfsmodell-Deltadaten einen Entwurfsunterschied zwischen dem ersten computerimplementierten Entwurfsmodell und einem zweiten computerimplementierten Entwurfsmodell beschreiben, wobei das zweite computerimplementierte Entwurfsmodell zweite Entwurfsmodellelemente umfasst, die die Architekturstruktur in einer zweiten Konfiguration darstellen, wobei die zweiten computerimplementierten Entwurfsmodellelemente strukturelle Elemente umfassen, die Wände, Böden, Dächer, Decken oder Fensteröffnungen umfassen, wobei das zweite computerimplementierte Entwurfsmodell aus einer Modifikation resultiert, die eine Hinzufügung, Entfernung oder Anpassung an der architektonischen Struktur umfasst, die an den ersten Entwurfsmodellelementen von einem Benutzer unter Verwendung eines computergestützten Entwurfs- (Computer-Aided Design, CAD) Softwarewerkzeugs auf dem Client-Computersystem durchgeführt wird, und wobei die Entwurfsmodell-Deltadaten Informationen umfassen, die weniger als entweder das erste computerimplementierte Entwurfsmodell oder das zweite computerimplementierte Entwurfsmodell beschreiben;
wobei das Server-Computersystem Gebäudedaten erzeugt, die sowohl auf dem ersten computerimplementierten Entwurfsmodell als auch auf den Entwurfsmodell-Deltadaten basieren, wobei die Gebäudedaten Eigenschaften der architektonischen Struktur beschreiben, die mindestens eines von Wänden, Böden, Dächern, Decken oder Fensteröffnungen in der zweiten Konfiguration umfasst;
wobei das Server-Computersystem, basierend auf den Gebäudedaten, eine Auswirkung der Modifikation auf eine vorhergesagte Eigenschaft der architektonischen Struktur analysiert, wodurch Auswirkungsanalysedaten erzeugt werden, wobei die vorhergesagte Eigenschaft der architektonischen Struktur mindestens eines der Folgenden umfasst: Energieverbrauch der architektonischen Struktur, Wasserverbrauch der architektonischen Struktur, Brennstoffverbrauch der architektonischen Struktur, verfügbare Tageslichtbeleuchtung, eine thermische Eigenschaft der architektonischen Struktur, Einhaltung einer Baunorm durch die architektonische Struktur, Kohlenstoff-Fußabdruck der architektonischen Struktur, Qualität des Innenraumklimas der architektonischen Struktur, Nutzung der Ausrüstung durch die architektonische Struktur, die Baukosten der architektonischen Struktur, die Betriebskosten der architektonischen Struktur oder die Wartungskosten der architektonischen Struktur; und
wobei das Server-Computersystem die Auswirkungsanalysedaten zur Präsentation auf dem Client-Computersystem als Entwurfsrückmeldung bereitstellt.

2. Verfahren nach Anspruch 1, wobei das Erzeugen von Gebäudedaten Folgendes umfasst:
das Server-Computersystem bildet die Entwurfsmodell-Deltadaten auf Gebäude-Deltadaten ab, die dafür konfiguriert sind, erste Gebäudedaten, die die architektonische Struktur in der ersten Konfiguration darstellen, auf zweite Gebäudedaten, die die architektonische Struktur in der zweiten Konfiguration darstellen, zu modifizieren; und
das Server-Computersystem erzeugt die Gebäudedaten basierend auf den Gebäude-Deltadaten und früheren Gebäudedaten, die die architektonische Struktur in der ersten Konfiguration darstellen.

3. Verfahren nach Anspruch 2, wobei das Analysieren der Auswirkung der Modifikation ferner Folgendes umfasst:
das Server-Computersystem analysiert die vorhergesagte Eigenschaft der architektonischen Struktur in der ersten Konfiguration basierend auf den früheren Gebäudedaten, wodurch erste Analysedaten erzeugt werden;
das Server-Computersystem analysiert die vorhergesagte Eigenschaft der architektonischen Struktur in der zweiten Konfiguration basierend auf den Gebäudedaten, wodurch zweite Analysedaten erzeugt werden; und
das Server-Computersystem vergleicht die ersten Analysedaten mit den zweiten Analysedaten, um die Auswirkung der Änderung auf die vorhergesagte Eigenschaft der architektonischen Struktur zu bestimmen.

4. Verfahren nach Anspruch 1, wobei das Analysieren der Auswirkung der Modifikation ferner umfasst, dass das Server-Computersystem die vorhergesagte Eigenschaft identifiziert, die durch die Modifikation beeinflusst wird.

5. Verfahren nach Anspruch 1, wobei das Analysieren der Auswirkung der Modifikation ferner das Bestimmen eines Wertes durch das Server-Computersystem umfasst, der die Auswirkung auf die vorhergesagte Eigenschaft darstellt.

6. Verfahren nach Anspruch 1, das ferner Folgendes umfasst:
das Client-Computersystem empfängt die Auswirkungsanalysedaten; und
das Client-Computersystem präsentiert die Auswirkungsanalyse als Entwurfsrückmeldung.

7. Verfahren nach Anspruch 6, wobei das Erzeugen von Gebäudedaten Folgendes umfasst:
das Server-Computersystem bildet die Entwurfsmodell-Deltadaten auf Gebäude-Deltadaten ab, die dafür konfiguriert sind, erste Gebäudedaten, die die architektonische Struktur in der ersten Konfiguration darstellen, auf zweite Gebäudedaten, die die architektonische Struktur in der zweiten Konfiguration darstellen, zu modifizieren; und
das Server-Computersystem erzeugt die Gebäudedaten basierend auf den Gebäude-Deltadaten und früheren Gebäudedaten, die die architektonische Struktur in der ersten Konfiguration darstellen.

8. Verfahren nach Anspruch 7, wobei das Analysieren der Auswirkung der Modifikation ferner Folgendes umfasst:
das Server-Computersystem analysiert die vorhergesagte Eigenschaft der architektonischen Struktur in der ersten Konfiguration basierend auf den früheren Gebäudedaten, wodurch erste Analysedaten erzeugt werden;
das Server-Computersystem analysiert die vorhergesagte Eigenschaft der architektonischen Struktur in der zweiten Konfiguration basierend auf den Gebäudedaten, wodurch zweite Analysedaten erzeugt werden; und
das Server-Computersystem vergleicht die ersten Analysedaten mit den zweiten Analysedaten, um die Auswirkung der Änderung auf die vorhergesagte Eigenschaft der architektonischen Struktur zu bestimmen.

9. Verfahren nach Anspruch 6, wobei das Analysieren der Auswirkung der Modifikation ferner umfasst, dass das Server-Computersystem die vorhergesagte Eigenschaft identifiziert, die durch die Modifikation beeinflusst wird.

10. Verfahren nach Anspruch 6, wobei das Analysieren der Auswirkung der Modifikation ferner das Bestimmen eines Wertes durch das Server-Computersystem umfasst, der die Auswirkung auf die vorhergesagte Eigenschaft darstellt.

11. Server-Computersystem, das Folgendes umfasst: mindestens einen Prozessor; und einen Speicher, der Anweisungen speichert, die dafür konfiguriert sind, den mindestens einen Prozessor anzuweisen, Folgendes auszuführen: unter Verwendung eines Server-Computersystems (206), das ein erstes computerimplementiertes Entwurfsmodell (208) besitzt, das erste computerimplementierte Entwurfsmodell, das erste Entwurfsmodellelemente umfasst, die eine architektonische Struktur in einer ersten Konfiguration darstellen, wobei die Strukturelemente der ersten Entwurfsmodellelemente Wände, Böden, Dächer, Decken oder Fensteröffnungen umfassen; Empfangen, an dem Server-Computersystem, von Entwurfsmodell-Deltadaten von einem Client-Computersystem (202), wobei die Entwurfsmodell-Deltadaten einen Entwurfsunterschied zwischen dem ersten computerimplementierten Entwurfsmodell und einem zweiten computerimplementierten Entwurfsmodell beschreiben, wobei das zweite computerimplementierte Entwurfsmodell zweite Entwurfsmodellelemente umfasst, die die Architekturstruktur in einer zweiten Konfiguration darstellen, wobei die zweiten computerimplementierten Entwurfsmodellelemente strukturelle Elemente umfassen, die Wände, Böden, Dächer, Decken oder Fensteröffnungen umfassen, wobei das zweite computerimplementierte Entwurfsmodell aus einer Modifikation resultiert, die eine Hinzufügung, Entfernung oder Anpassung an der architektonischen Struktur umfasst, die an den ersten Entwurfsmodellelementen von einem Benutzer unter Verwendung eines computergestützten Entwurfs- (CAD) Softwarewerkzeugs auf dem Client-Computersystem durchgeführt wird, und wobei die Entwurfsmodell-Deltadaten Informationen umfassen, die weniger als entweder das erste computerimplementierte Entwurfsmodell oder das zweite computerimplementierte Entwurfsmodell beschreiben; Erzeugen von Gebäudedaten, die sowohl auf dem ersten computerimplementierten Entwurfsmodell als auch auf den Entwurfsmodell-Deltadaten basieren, wobei die Gebäudedaten Eigenschaften der architektonischen Struktur beschreiben, die mindestens eines von Wänden, Böden, Dächern, Decken oder Fensteröffnungen in der zweiten Konfiguration umfasst; Analysieren, basierend auf den Gebäudedaten, einer Auswirkung der Modifikation auf eine vorhergesagte Eigenschaft der architektonischen Struktur, wodurch Auswirkungsanalysedaten erzeugt werden, wobei die vorhergesagte Eigenschaft der architektonischen Struktur mindestens eines der Folgenden umfasst:
Energieverbrauch der architektonischen Struktur, Wasserverbrauch der architektonischen Struktur, Brennstoffverbrauch der architektonischen Struktur, verfügbare Tageslichtbeleuchtung, eine thermische Eigenschaft der architektonischen Struktur, Einhaltung einer Baunorm durch die architektonische Struktur, Kohlenstoff-Fußabdruck der architektonischen Struktur, Qualität des Innenraumklimas der architektonischen Struktur, Nutzung der Ausrüstung durch die architektonische Struktur, die Baukosten der architektonischen Struktur, die Betriebskosten der architektonischen Struktur oder die Wartungskosten der architektonischen Struktur; und Bereitstellen der Auswirkungsanalysedaten zur Präsentation auf dem Client-Computersystem als Entwurfsrückmeldung bereitstellt.

## Revendications

1. Procédé mis en oeuvre par ordinateur pour l'analyse d'une structure architecturale, comprenant :
un système informatique serveur (206) possédant un premier modèle de conception mis en oeuvre par ordinateur (208), le premier modèle de conception mis en oeuvre par ordinateur comprenant des premiers éléments de modèle de conception représentant une structure architecturale dans une première configuration, les premiers éléments de modèle de conception comprenant des éléments structurels comprenant des murs, des planchers, des toits, des plafonds ou des fenêtrages ; par la suite
la réception, par le système informatique serveur, de données delta de modèle de conception d'un système informatique client (202), les données delta de modèle de conception décrivant une différence de conception entre le premier modèle de conception mis en oeuvre par ordinateur et un deuxième modèle de conception mis en oeuvre par ordinateur, le deuxième modèle de conception mis en oeuvre par ordinateur comprenant des deuxièmes éléments de modèle de conception représentant la structure architecturale dans une deuxième configuration, les deuxièmes éléments de modèle de conception mis en oeuvre par ordinateur comprenant des éléments structurels comprenant des murs, des planchers, des toits, des plafonds ou des fenêtrages, dans lequel le deuxième modèle de conception mis en oeuvre par ordinateur résulte d'une modification comprenant un ajout, une suppression ou un ajustement apporté à la structure architecturale qui est réalisé sur les premiers éléments de modèle de conception par un utilisateur à l'aide d'un outil logiciel de conception assistée par ordinateur (CAO) sur le système informatique client, et dans lequel les données delta de modèle de conception comprennent des informations qui décrivent moins que le premier modèle de conception mis en oeuvre par ordinateur ou que le deuxième modèle de conception mis en oeuvre par ordinateur ;
la production, par le système informatique serveur ,de données de construction, en fonction à la fois du premier modèle de conception mis en oeuvre par ordinateur et des données delta de modèle de conception, les données de construction décrivant des caractéristiques de la structure architecturale comportant au moins des murs, des planchers, des toits, des plafonds ou des fenêtrages dans la deuxième configuration ;
l'analyse, par le système informatique serveur, en fonction des données de construction, d'un impact de la modification sur une caractéristique prédite de la structure architecturale, produisant ainsi des données d'analyse d'impact, dans lequel la caractéristique prédite de la structure architecturale comporte au moins une consommation d'énergie par la structure architecturale, une consommation d'eau par la structure architecturale, une consommation de carburant par la structure architecturale, un éclairage naturel disponible, une caractéristique thermique de la structure architecturale, une conformité de la structure architecturale avec une norme de construction, une empreinte carbone de la structure architecturale, une qualité d'environnement intérieur de la structure architecturale, une utilisation d'équipements par la structure architecturale, un coût de construction de la structure architecturale, un coût d'exploitation de la structure architecturale ou un coût d'entretien de la structure architecturale ; et
la fourniture, par le système informatique serveur, les données d'analyse d'impact en vue de leur présentation au système informatique client en tant que retour d'informations de conception.

2. Procédé selon la revendication 1, dans lequel la production de données de construction comprend :
le mappage, par le système informatique serveur, des données delta de modèle de conception sur des données delta de construction configurées pour modifier des premières données de construction, représentant la structure architecturale dans la première configuration, en deuxièmes données de construction, représentant la structure architecturale dans la deuxième configuration ; et
la production, par le système informatique serveur, des données de construction en fonction des données delta de construction et de données de construction antérieures représentant la structure architecturale dans la première configuration.

3. Procédé selon la revendication 2, dans lequel l'analyse de l'impact de la modification comprend en outre :
l'analyse, par le système informatique serveur, des caractéristiques prédites de la structure architecturale dans la première configuration en fonction des données de construction antérieures, produisant ainsi des premières données d'analyse ;
l'analyse, par le système informatique serveur, de la caractéristique prédite de la structure architecturale dans la deuxième configuration en fonction des données de construction, produisant ainsi des deuxièmes données d'analyse ; et
la comparaison, par le système informatique serveur, des premières données d'analyse aux deuxièmes données d'analyse pour déterminer l'impact de la modification sur la caractéristique prédite de la structure architecturale.

4. Procédé selon la revendication 1, dans lequel l'analyse de l'impact de la modification comprend en outre l'identification, par le système informatique serveur, de la caractéristique prédite impactée par la modification.

5. Procédé selon la revendication 1, dans lequel l'analyse de l'impact de la modification comprend en outre la détermination ,par le système informatique serveur, d'une valeur représentant l'impact sur la caractéristique prédite.

6. Procédé selon la revendication 1, comprenant en outre :
la réception, par le système informatique client, des données d'analyse d'impact ; et
la présentation, par le système informatique client, de l'analyse d'impact en tant que retour d'informations de conception.

7. Procédé selon la revendication 6, dans lequel la production de données de construction comprend :
le mappage, par le système informatique serveur, de données delta de modèle de conception sur des données delta de construction configurées pour modifier des premières données de construction, représentant la structure architecturale dans la première configuration, en deuxièmes données de construction, représentant la structure architecturale dans la deuxième configuration ; et
la production, par le système informatique serveur, des données delta de construction en fonction des données delta de construction et de données de construction antérieures représentant la structure architecturale dans la première configuration.

8. Procédé selon la revendication 7, dans lequel l'analyse de l'impact de la modification comprend en outre :
l'analyse, par le système informatique serveur, de la caractéristique prédite de la structure architecturale dans la première configuration en fonction des données de construction antérieures, produisant ainsi des premières données d'analyse ;
l'analyse, par le système informatique serveur, de la caractéristique prédite de la structure architecturale dans la deuxième configuration en fonction des données de construction, produisant ainsi des deuxièmes données d'analyse ; et
la comparaison, par le système informatique serveur, des premières données d'analyse aux deuxièmes données d'analyse pour déterminer l'impact de la modification sur la caractéristique prédite de la structure architecturale.

9. Procédé selon la revendication 6, dans lequel l'analyse de l'impact de la modification comprend en outre l'identification, par le système informatique serveur, de la caractéristique prédite impactée par la modification.

10. Procédé selon la revendication 6, dans lequel l'analyse de l'impact de la modification comprend en outre la détermination, par le système informatique serveur, d'une valeur représentant l'impact sur la caractéristique prédite.

11. Système informatique serveur comprenant : au moins un processeur ; et une mémoire stockant des instructions configurées pour commander à au moins un processeur de réaliser les actions suivantes : l'utilisation d'un système informatique serveur (206) qui possède un premier modèle de conception mis en oeuvre par ordinateur (208), le premier modèle de conception mis en oeuvre par ordinateur comprenant des premiers éléments de modèle de conception représentant une structure architecturale dans une première configuration, les premiers éléments de modèle de conception comprenant des murs, des planchers, des toits, des plafonds ou des fenêtrages ; la réception, au niveau du système informatique serveur, de données delta de modèle de conception à partir d'un système informatique client (202), les données delta de modèle de conception décrivant une différence de conception entre le premier modèle de conception mis en oeuvre par ordinateur et un deuxième modèle de conception mis en oeuvre par ordinateur et un deuxième modèle de conception mis en oeuvre par ordinateur, le deuxième modèle de conception mis en oeuvre par ordinateur comprenant des deuxièmes éléments de modèle de conception représentant la structure architecturale dans une deuxième configuration, les deuxièmes éléments de modèle de conception mis en oeuvre par ordinateur comprenant des éléments structurels comprenant des murs, des planchers, des toits, des plafonds ou des fenêtrages, dans lequel le deuxième modèle de conception mis en oeuvre par ordinateur résulte d'une modification comprenant un ajout, une suppression ou un ajustement apporté à la structure architecturale qui est réalisé sur les premiers éléments de modèle de conception par un utilisateur à l'aide d'un outil logiciel de conception assistée par ordinateur (CAO) au niveau du système informatique client, et dans lequel les données delta de modèle de conception comprennent des informations qui décrivent moins que le premier modèle de conception mis en oeuvre par ordinateur ou que le deuxième modèle de conception mis en oeuvre par ordinateur ; la production de données de construction, en fonction à la fois du premier modèle de conception mis en oeuvre par ordinateur et des données delta de modèle de conception, dans lequel les données de construction décrivent des caractéristiques de la structure architecturale comportant au moins des murs, des planchers, des toits, des plafonds ou des fenêtrages dans la deuxième configuration ; l'analyse, en fonction des données de construction, d'un impact de la modification sur une caractéristique prédite de la structure architecturale, produisant ainsi des données d'analyse d'impact, dans lequel la caractéristique prédite de la structure architecturale comprend au moins une consommation d'énergie par la structure architecturale, une consommation d'eau par la structure architecturale, une consommation de carburant par la structure architecturale, un éclairage naturel disponible, une caractéristique thermique de la structure architecturale, une conformité de la structure architecturale avec une norme de construction, une empreinte carbone de la structure architecturale, une qualité d'environnement intérieur de la structure architecturale, une utilisation d'équipements par la structure architecturale, un coût de construction de la structure architecturale, un coût opérationnel de la structure architecturale ou un coût d'entretien de la structure architecturale ; et la fourniture des données d'analyse d'impact en vue de leur présentation au système informatique client en tant que retour d'informations de conception.
